# EUROPEAN PATENT APPLICATION

(11) **EP 4 465 066 A1**
(43) Date of publication of application: **20.11.2024**
(21) Application number: 23208418.6
(22) Date of filing: 08.11.2023
(51) Int. Cl.: G01R 33/00, G01R 33/09

(54) **MAGNETIC-TUNNEL-JUNCTION DEVICES FOR A MAGNETIC-FIELD SENSOR**

(30) Priority: 15.05.2023 US 202318197147
(71) Applicant: GLOBALFOUNDRIES Singapore Pte. Ltd., Singapore 738406 (SG)
(72) Inventor: TOH, Eng-Huat, 738406 Singapore (SG); SIAH, Soh Yun, 738406 Singapore (SG); YOU, Young Seon, 738406 Singapore (SG); YAMANE, Kazutaka, 738406 Singapore (SG); NAIK, Vinayak Bharat, 738406 Singapore (SG); SIMON, Chan Tze Ho, 738406 Singapore (SG)
(74) Representative: Lambacher, Michael

(57) **Abstract**

Structures including a magnetic-tunnel-junction device and methods of forming such structures. The structure comprises a magnetic-tunnel-junction device that includes a first electrode having a first sidewall, a second electrode having a second sidewall facing the first sidewall of the first electrode, a pinned layer adjacent to the first sidewall of the first electrode, a free layer adjacent to the second sidewall of the second electrode, and a tunnel barrier layer between the free layer and the pinned layer.

## Description

### BACKGROUND

This disclosure relates to integrated circuits and semiconductor device fabrication and, more specifically, to structures including a magnetic-tunnel-junction device and methods of forming such structures.

Magnetic-field sensors are found in various commercial products, such as household appliances, gaming systems, construction equipment, utility meters, and motor vehicles. A magnetic-field sensor may be configured to on sense a direction of a magnetic field. A magnetic field is a vector quantity characterized at a given position by a field strength and a field direction. Conventional magnetic-field sensors, which are planar devices, have a low sensitivity when attempting to sense a magnetic field having a field direction that is parallel to a surface on which the magnetic-field sensor is located.

Improved structures including a magnetic-tunnel-junction device and methods of forming such structures are needed.

### SUMMARY

According to an embodiment of the invention, a structure for a magnetic-field sensor is provided. The structure comprises a magnetic-tunnel-junction device that includes a first electrode having a first sidewall, a second electrode having a second sidewall facing the first sidewall of the first electrode, a pinned layer adjacent to the first sidewall of the first electrode, a free layer adjacent to the second sidewall of the second electrode, and a tunnel barrier layer between the free layer and the pinned layer.
The pinned layer of the first magnetic-tunnel junction device may adjoin the first sidewall of the first electrode. Moreover, the free layer of the first magnetic-tunnel junction may adjoin the second sidewall of the second electrode.
Further, the structure may additionally comprise a first terminal of a Wheatstone bridge, and a second magnetic-tunnel junction device including a third electrode having a third sidewall, a fourth electrode having a fourth sidewall facing the third sidewall of the third electrode, a second pinned layer adjacent to the third sidewall of the third electrode, a second free layer adjacent to the fourth sidewall of the fourth electrode, and a second tunnel barrier layer between the second free layer and the second pinned layer, wherein the first free layer may be coupled by the first electrode to the first terminal, and the second free layer may be coupled by the third electrode to the first terminal.
Further, the structure may additionally comprise a second terminal of the Wheatstone bridge, wherein the second electrode may be coupled to the second terminal; additionally, the structure may further comprise a third terminal of the Wheatstone bridge, wherein the fourth electrode may be coupled to the third terminal.
The first pinned layer of the above mentioned structure may have a first magnetization, the second pinned layer may have a second magnetization, and the first magnetization may be aligned antiparallel to the second magnetization. Moreover, the first magnetization may be oriented perpendicular to the first sidewall of the first electrode, and the second magnetization may be oriented perpendicular to the third sidewall of the third electrode.
Moreover, the first electrode of the above mentioned structure may be spaced from the third electrode by a gap, and the first terminal may include an interconnect that is coupled to the first electrode and the third electrode, and the interconnect may extend across the gap.
The above structure may further comprise a semiconductor substrate having a top surface, wherein the first pinned layer, the first tunnel barrier layer, and the first free layer may share a planar top surface that may be coplanar with the top surface of the semiconductor substrate. Additionally, the structure may comprise an interconnect structure over the semiconductor substrate, the interconnect structure including an interlayer dielectric layer, wherein the first electrode, the first pinned layer, and the first tunnel barrier layer may be positioned in the interconnect structure.
Alternatively, the structure may further comprise a semiconductor substrate having a top surface, wherein the first electrode, the first pinned layer, and the first tunnel barrier layer may share a planar top surface that may be oriented at an acute angle relative to the top surface of the semiconductor substrate.
In addition to the above features, according to one implementation the structure may further comprise a dielectric layer over the first electrode, wherein the dielectric layer may have a top surface, and wherein the first pinned layer may include a first section on the top surface of the dielectric layer and a second section adjacent to the first sidewall of the first electrode. Further, the first section and the second section of the first pinned layer may have substantially equal thicknesses. Alternatively, the first pinned layer may have a section with a top surface that is coplanar with the top surface of the dielectric layer.
According to another implementation the structure may further comprise a dielectric layer adjacent to the first electrode, wherein the first electrode may be positioned between the dielectric layer and the first pinned layer.
In addition, the first free layer may include a first section adjacent to the second sidewall of the second electrode and a second section adjacent to the first section, and the structure may further comprise a dielectric layer adjacent to the second section of the first free layer.
According to a further implementation the structure may further comprise a second magnetic-tunnel junction device including a third electrode having a third sidewall, a second pinned layer adjacent to the first sidewall of the first electrode, a second free layer adjacent to the third sidewall of the third electrode, and a second tunnel barrier layer between the second free layer and the second pinned layer.

According to an embodiment of the invention, a method of forming a structure for a magnetic-field sensor is provided. The method comprises forming a magnetic-tunnel junction device that includes a first electrode having a first sidewall, a second electrode having a second sidewall facing the first sidewall of the first electrode, a pinned layer adjacent to the first sidewall of the first electrode, a free layer adjacent to the second sidewall of the second electrode, and a tunnel barrier layer between the free layer and the pinned layer.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a diagrammatic view of a circuit for a magnetic-field sensor in accordance with embodiments of the invention.
FIG. 2 is a perspective view of a structure for the magnetic-field sensor of FIG. 1.
FIG. 3 is a cross-sectional view of a pair of the magnetic-tunnel junction devices in FIG. 2.
FIG. 3A is a cross-sectional view of another pair of the magnetic-tunnel junction devices in FIG. 2.
FIG. 4 is a cross-sectional view of a pair of magnetic-tunnel-junction devices in accordance with alternative embodiments.
FIG. 5 is a cross-sectional view of a pair of magnetic-tunnel-junction devices in accordance with alternative embodiments.
FIG. 6 is a cross-sectional view of a pair of magnetic-tunnel-junction devices in accordance with alternative embodiments.
FIG. 7 is a cross-sectional view of a pair of magnetic-tunnel-junction devices in accordance with alternative embodiments.
FIG. 8 is a cross-sectional view of a pair of magnetic-tunnel-junction devices at an initial fabrication stage of a processing method in accordance with alternative embodiments.
FIG. 9 is a cross-sectional view of the pair of magnetic-tunnel-junction devices at a fabrication stage subsequent to FIG. 8.
FIG. 10 is a cross-sectional view of the pair of magnetic-tunnel-junction devices at a fabrication stage subsequent to FIG. 9.
FIG. 11 is a cross-sectional view of a pair of magnetic-tunnel-junction devices in accordance with alternative embodiments.
FIG. 12 is a cross-sectional view of a pair of magnetic-tunnel-junction devices in accordance with alternative embodiments.

### DETAILED DESCRIPTION

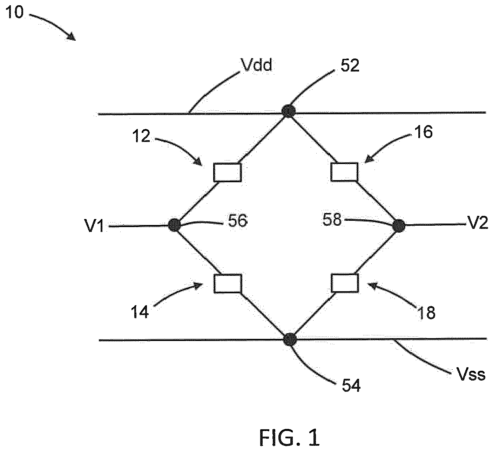

With reference to FIGS. 1, 2, 3, 3A and in accordance with embodiments of the invention, a structure 10 for a magnetic-field sensor includes multiple magnetic-tunnel-junction devices 12, 14, 16, 18 disposed in an interconnect structure 46 that is formed over a semiconductor substrate 40. Each of the magnetic-tunnel-junction devices 12, 14, 16, 18 includes an electrode 20, a fixed or pinned layer 22, a tunnel barrier layer 24, a free layer 26, and an electrode 30. In each of the magnetic-tunnel junction devices 12, 14, 16, 18, the pinned layer 22, tunnel barrier layer 24, and free layer 26 may be positioned in a lateral direction between the electrode 20 and the electrode 30 with the tunnel barrier layer 24 positioned between the pinned layer 22 and the free layer 26, the pinned layer 22 positioned adjacent to the electrode 20, and the free layer 26 positioned adjacent to the electrode 30.

The pinned layer 22 may include a reference layer comprised of a magnetic material, such as a cobalt-iron-boron alloy, a pair of synthetic antiferromagnetic layers each including multiple alternating sublayers comprised of cobalt and platinum, and a spacer comprised of, for example, ruthenium that is arranged between the synthetic antiferromagnetic layers. The magnetization of the pinned layer 22 is pinned such that the magnetization is unable to flip (i.e., rotate) when exposed to an external magnetic field during operation as a magnetic-field sensor. The tunnel barrier layer 24 may be comprised of a non-magnetic and electrically-insulating material, such as magnesium oxide or aluminum oxide. The free layer 26 may be comprised of a magnetic material, such as a cobalt-iron-boron alloy. The magnetization of the free layer 26 is not pinned such that the magnetization can flip (i.e., rotate) in response to exposure to an external magnetic field during operation as a magnetic-field sensor. The electrode 20 and the electrode 30 are comprised of a conductive material, such as tantalum and/or ruthenium.

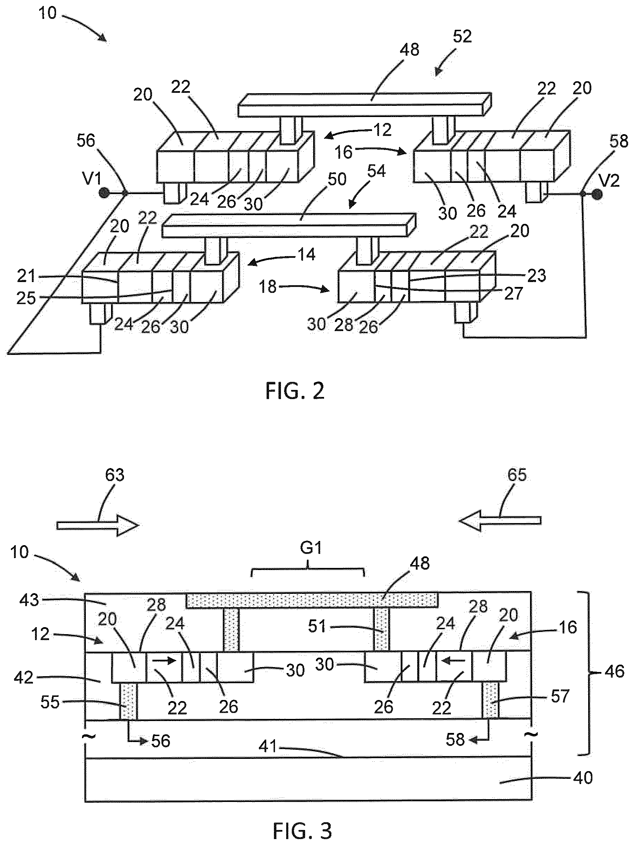

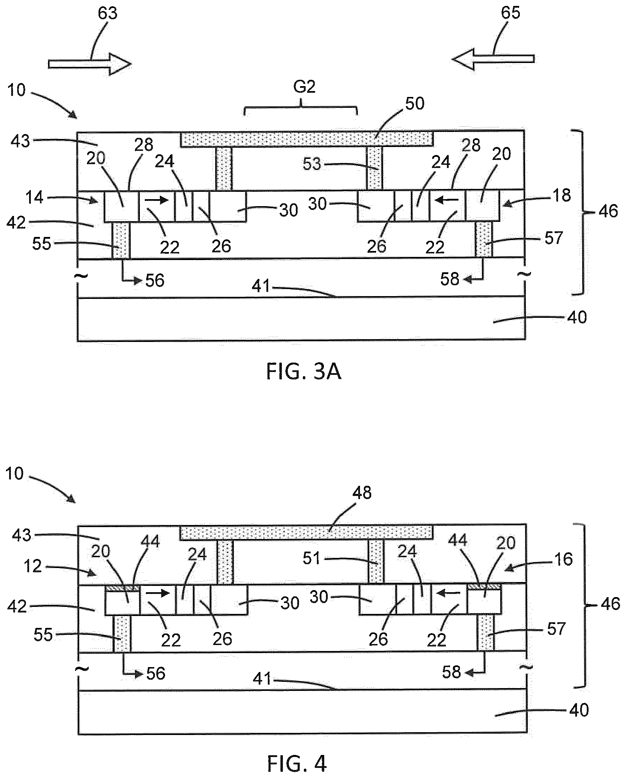

The magnetic orientation or magnetization of each pinned layer 22 is pinned to a particular direction, as diagrammatically shown by the single-headed arrows in FIGS. 3, 3A, while the magnetic orientation or magnetization of each free layer 26 may be rotated by the application of an external magnetic field. In particular, the magnetization 34 of each free layer 26 may be rotated by an external magnetic field to be aligned in a direction parallel to the magnetization of the associated pinned layer 22, or rotated by the external magnetic field to be aligned in a direction antiparallel to the magnetization of the associate the pinned layer 22, contingent upon the direction of the external magnetic field being sensed by the magnetic-field sensor. The electrical resistance across the tunnel barrier layer 24 between the pinned layer 22 and the free layer 26 in the antiparallel state is greater than the electrical resistance across the tunnel barrier layer 24 between the pinned layer 22 and the free layer 26 in the parallel state.

In an embodiment the magnetic-tunnel-junction devices 12, 14, 16, 18 may have identical constructions. The electrode 20 has a sidewall 21 that is arranged adjacent to a sidewall of the pinned layer 22. In an embodiment, the sidewall 21 of the electrode 20 may adjoin and/or share a boundary with the adjacent sidewall of the pinned layer 22. The pinned layer 22 has a sidewall 23 that is arranged adjacent to a sidewall of the tunnel barrier layer 24. In an embodiment, the sidewall 23 of the pinned layer 22 may adjoin and/or share a boundary with the adjacent sidewall of the tunnel barrier layer 24. The tunnel barrier layer 24 has a sidewall 25 that is arranged adjacent to a sidewall of the free layer 26. In an embodiment, the sidewall 25 of the tunnel barrier layer 24 may adjoin and/or share a boundary with an adjacent sidewall of the free layer 26. The electrode 30 has a sidewall 27 that is arranged adjacent to a sidewall of the free layer 26. In an embodiment, the sidewall 27 of each electrode 30 may adjoin and/or share a boundary with the adjacent sidewall of the free layer 26. The free layer 26 is positioned between the sidewall 25 of the tunnel barrier layer 24 and the sidewall 27 of the electrode 30. The sidewall 27 of the electrode 30 faces (i.e., is oriented toward) the sidewall 21 of the electrode 20, and the pinned layer 22, tunnel barrier layer 24, and free layer 26 are positioned between the sidewall 21 and the sidewall 27.

The magnetic-tunnel-junction devices 12, 14, 16, 18 may be formed in an interlayer dielectric layer 42 of the interconnect structure 46. In an embodiment, the pinned layer 22, tunnel barrier layer 24, and free layer 26 of each of the magnetic-tunnel junction devices 12, 14, 16, 18 may share a top surface 28. The sharing of the top surface 28 is enabled by forming the pinned layer 22, tunnel barrier layer 24, and free layer 26 by individual depositions and planarization by a common chemical-mechanical polishing process, which is enabled by the horizontal orientation of the magnetic-tunnel junction devices 12, 14, 16, 18. In an embodiment, the electrode 20 and/or the electrode 30 may also share the top surface 28. The top surface 28, which may be coplanar with a top surface of the interlayer dielectric layer 42, may be oriented parallel to a reference plane defined by a top surface 41 of the semiconductor substrate 40. In an alternative embodiment, the top surface 28 may be oriented at an acute angle relative to a reference plane defined by the top surface 41 of the semiconductor substrate 40. In an embodiment, the sidewalls 21, 23, 25, and 27 may extend from the shared top surface 28 to a shared bottom surface opposite to the top surface 28.

The interconnect structure 46 includes a terminal 52 that is coupled to a voltage source (Vdd), and a terminal 54 that is coupled with a different voltage source (Vss), which may be ground. The terminal 52 may include an interconnect 48 that is connected by vias 51 to the electrodes 30 of the magnetic-tunnel junction devices 12 and 16. The interconnect 48 of the terminal 52 may extend across a gap G1 between the electrode 30 of the magnetic-tunnel-junction device 12 and the electrode 30 of the magnetic-tunnel junction device 16. The terminal 54 may include an interconnect 50 that is connected by vias 53 to the electrodes 30 of the magnetic-tunnel-junction devices 14 and 18. The interconnect 50 of the terminal 54 may extend across a gap G2 between the electrode 30 of the magnetic-tunnel-junction device 14 and the electrode 30 of the magnetic-tunnel junction device 16.

The interconnect structure 46 includes a terminal 56 at which a voltage (V1) is output in the presence of an external magnetic field applied during operation as a magnetic-field sensor, and a terminal 58 at which, during operation, a voltage (V2) is output in the presence of an external magnetic field applied during operation as a magnetic-field sensor. The output voltages V1, V2 are contingent upon the field direction of the external magnetic field that is sensed. The terminal 56 may be connected by metallization including vias 55 to the electrodes 20 of the magnetic-tunnel-junction device 12 and 14. The terminal 58 may be connected by metallization including vias 57 to the electrodes 20 of the magnetic-tunnel-junction devices 16 and 18. The terminals 52, 54, 56, 58 and their connections may be formed by etching trenches and vias in an interlayer dielectric layer 43 of the interconnect structure 46 and then filling the trenches and vias with a metal, such as copper or aluminum.

The magnetic-tunnel-junction devices 12, 16 may be arranged in a leg of a Wheatstone bridge array, and the magnetic-tunnel-junction devices 14, 18 may be arranged in another leg of the Wheatstone bridge array. The magnetization of the pinned layer 22 of the magnetic-tunnel-junction device 12 and the magnetization of the pinned layer 22 of the magnetic-tunnel-junction device 16 may be oriented perpendicular to the sidewall 21 of the adjacent electrode 20 and pointed in a direction away from the sidewall 21. The magnetization of the pinned layer 22 of the magnetic-tunnel junction device 12 may be aligned antiparallel to the magnetization of the pinned layer 22 of the magnetic-tunnel junction device 16. Similarly, the magnetization of the pinned layer 22 of the magnetic-tunnel junction device 14 and the magnetization of the pinned layer 22 of the magnetic-tunnel junction device 18 may be oriented perpendicular to the sidewall 21 of the adjacent electrode 20 and pointed in a direction away from the sidewall 21. The magnetization of the pinned layer 22 of the magnetic-tunnel junction device 14 may be aligned antiparallel to the magnetization of the pinned layer 22 of the magnetic-tunnel-junction device 18. In an embodiment, the directions for the respective magnetizations of the pinned layers 22 may be aligned parallel or substantially parallel to the top surface 41 of the semiconductor substrate 40. The sensing margin of the structure 10 may be increased by adding one or more magnetic-tunnel-junction layer stacks to each of the magnetic-tunnel junction devices 12, 14, 16, 18 with either a series connection or a parallel connection.

The structure 10 may be used to sense an in-plane external magnetic field 63. If the structure 10 is placed in the in-plane external magnetic field 63, the magnetization of the free layer 26 of the magnetic-tunnel-junction device 12 and the free layer 26 of the magnetic-tunnel-junction device 14 may be rotated to be parallel to the respective pinned layers 22, and the magnetization of the free layer 26 of the magnetic-tunnel junction device 16 and the free layer 26 of the magnetic-tunnel-junction device 18 will be rotated to be antiparallel to the respective pinned layers 22. The magnetic-tunnel junction devices 12, 14 are thereby placed in their low resistance-states and the magnetic-tunnel junction devices 16, 18 are thereby placed in their high resistance-states such that the legs of the Wheatstone bridge output voltages V1, V2 at the terminals 56, 58 and the potential difference between the terminals 56, 58 indicates the existence of the in-plane external magnetic field 63.

If the structure 10 is placed in an in-plane external magnetic field 65 having a direction that is opposite to the direction of the in-plane external magnetic field 63, the magnetization of the free layer 26 of the magnetic-tunnel junction device 12 and the free layer 26 of the magnetic-tunnel-junction device 14 may be rotated to be antiparallel to the respective pinned layers 22, and the magnetization of the free layer 26 of the magnetic-tunnel-junction device 16 and the free layer 26 of the magnetic-tunnel junction device 18 may be rotated to be parallel to the respective pinned layers 22. The magnetic-tunnel-junction devices 12, 14 are thereby placed in their high resistance-states and the magnetic-tunnel junction devices 16, 18 are thereby placed in their low resistance-states such that the legs of the Wheatstone bridge output the voltages V1, V2 at the terminals 56, 58 and the potential difference between the terminals 56, 58 indicates the existence of the in-plane external magnetic field 65.

With reference to FIG. 4 in which like reference numerals refer to like features in FIG. 3 and in accordance with alternative embodiments, the structure 10 may be modified to add sections of a dielectric layer 44 that are arranged over the electrodes 20 of the magnetic-tunnel-junction devices 12, 16. The added sections of the dielectric layer 44 may function as hardmasks during the formation of the pinned layer 22, tunnel barrier layer 24, and free layer 26 of each of the magnetic-tunnel junction devices 12, 16. Although not shown, similar sections of the dielectric layer 44 may be arranged over the electrodes 20 of the magnetic-tunnel-junction devices 14, 18.

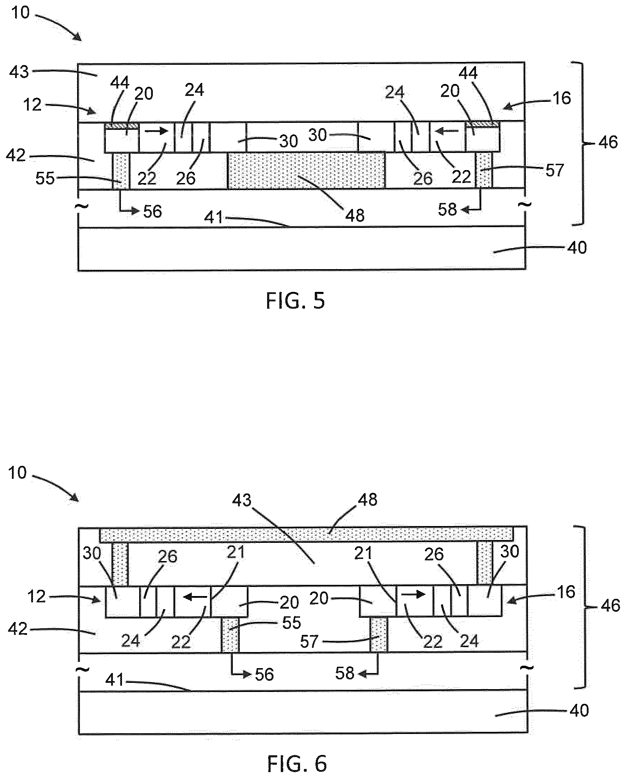

With reference to FIG. 5 in which like reference numerals refer to like features in FIG. 3 and in accordance with alternative embodiments, the structure 10 may be modified to relocate the interconnect 48 of the terminal 52 to a position in the interlayer dielectric layer 42 beneath the electrodes 20 of the magnetic-tunnel junction devices 12, 16, in addition to the modification adding the sections of the dielectric layer 44. The interconnect 48 may be arranged in the same level in the interconnect structure 46 as the vias 55, 57. Although not shown, the interconnect 50 of the terminal 54 may be arranged in a similar manner in the interlayer dielectric layer 42 below the electrodes 20 of the magnetic-tunnel junction devices 14, 18.

With reference to FIG. 6 in which like reference numerals refer to like features in FIG. 3 and in accordance with alternative embodiments, the structure 10 may be modified such that the magnetization of the pinned layers 22 of the magnetic-tunnel junction devices 12 and 14 are oppositely directed and the electrodes 20 are positioned adjacent to each other. The interconnect 48 of the terminal 52 may extend across the gap G1 between the electrode 20 of the magnetic-tunnel-junction device 12 and the electrode 20 of the magnetic-tunnel junction device 16. Although not shown, the magnetic-tunnel junction devices 14, 18 may be similarly modified.

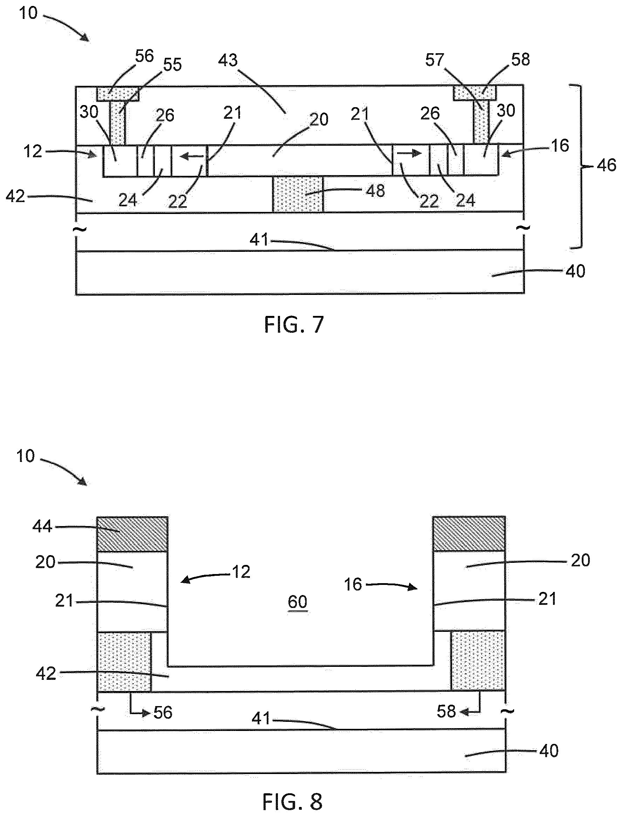

With reference to FIG. 7 in which like reference numerals refer to like features in FIG. 3 and in accordance with alternative embodiments, the electrodes 20 of the magnetic-tunnel junction devices 12, 16 may be consolidated into a shared electrode 20, and the connections to the interconnect 48 of the terminal 52 and the vias 55, 57 may be inverted. The gap G1 is eliminated because of the sharing of the electrode 20. Although not shown, the magnetic-tunnel-junction devices 14, 18 may be similarly modified.

With reference to FIG. 8 and in accordance with alternative embodiments, the structure 10 may be formed by depositing a conductor layer on the interlayer dielectric layer 42, forming the sections of the dielectric layer 44 over the deposited conductor layer, and patterning the conductor layer with an etching process to define the electrodes 20 of the magnetic-tunnel-junction devices 12, 16. The sections of the dielectric layer 44 function as a hardmask during the etching process. A cavity 60 is defined by the etching process as an open space between the electrodes 20, and the etching process may extend the cavity 60 to a shallow depth into the interlayer dielectric layer 42. The sidewall 21 of each electrode 20 borders the cavity 60.

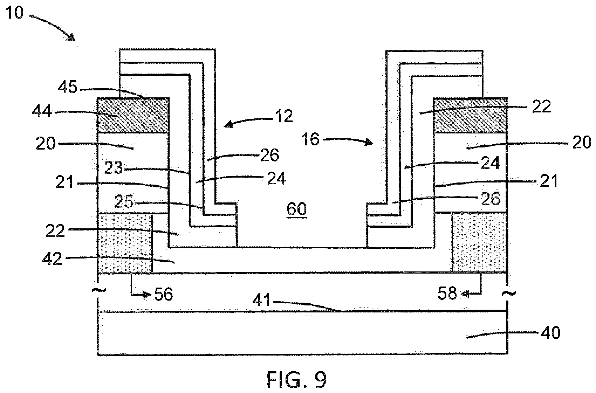

With reference to FIG. 9 and at a fabrication stage subsequent to FIG. 8, the pinned layer 22, tunnel barrier layer 24, and free layer 26 may be sequentially deposited and patterned by lithography and etching processes to form the magnetic-tunnel junction devices 12, 16. The patterned pinned layer 22, tunnel barrier layer 24, and free layer 26 of each of the magnetic-tunnel junction devices 12, 16 include respective sections that are positioned in a lateral direction adjacent to the sidewall 21 of the electrode 20. The patterned pinned layer 22, tunnel barrier layer 24, and free layer 26 of each of the magnetic-tunnel-junction devices 12, 16 may each include a section that overlaps with a portion of a top surface 45 of the associated section of the dielectric layer 44 and a section that overlaps with a portion of the interlayer dielectric layer 42 at the bottom of the cavity 60. In an embodiment, the different sections of the pinned layer 22, tunnel barrier layer 24, and free layer 26 of each of the magnetic-tunnel junction devices 12, 16 may be conformally deposited with a uniform or substantially uniform thickness that is independent of the underlying topography. The pinned layer 22, the tunnel barrier layer 24, and the free layer 26 of each of the magnetic-tunnel junction devices 12, 16 may be considered to wrap around the associated electrode 20 and section of the dielectric layer 44.

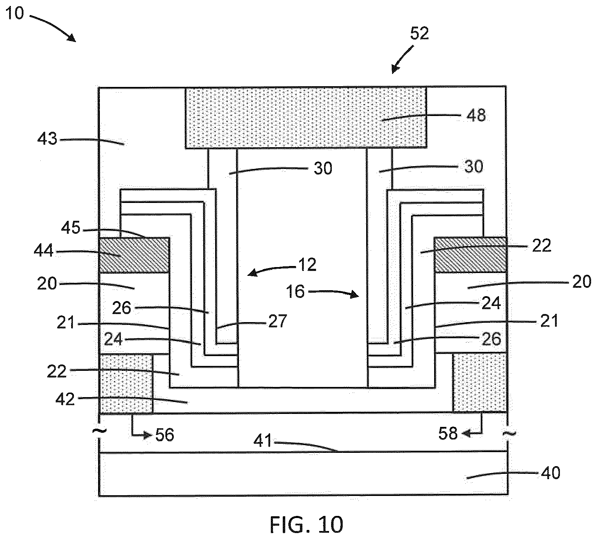

With reference to FIG. 10 and at a fabrication stage subsequent to FIG. 9, the interlayer dielectric layer 43 may be formed, and the electrodes 30 of the magnetic-tunnel-junction devices 12, 16 and the interconnect 48 included in the terminal 52 may be formed in the interlayer dielectric layer 43. For each of the magnetic-tunnel-junction devices 12, 16, the electrode 30 is positioned adjacent to the sections of the pinned layer 22, tunnel barrier layer 24, and free layer 26 adjacent to the sidewall 21 of the electrode 20, and the electrode 30 overlaps with the free layer 26. The electrodes 30 and the interconnect 48 may be formed by patterning openings in the interlayer dielectric layer 43, depositing a layer of a conductor, and planarizing the deposited layer. The electrodes 30 may be directly connected to different portions of the interconnect 48 included in the terminal 52. Although not shown, the magnetic-tunnel-junction devices 14, 18 of the structure 10 may have a similar construction.

In an embodiment, multiple structures 10 may be deployed with different orientations in order to sense magnetic fields in multiple directions, such as the x-, y-, and z-directions within a Cartesian coordinate frame.

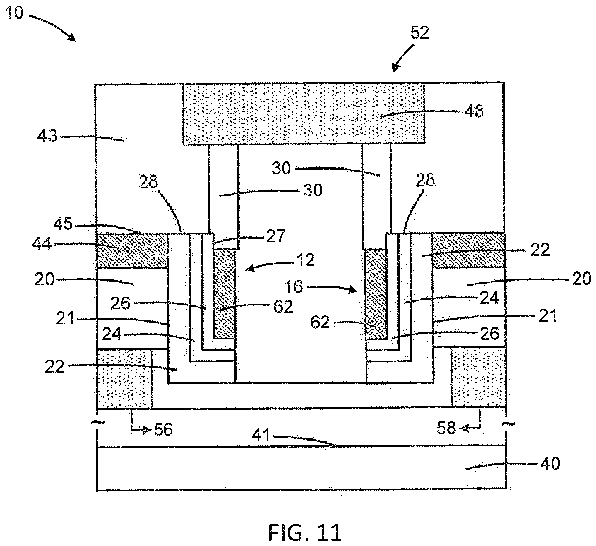

With reference to FIG. 11 in which like reference numerals refer to like features in FIG. 10 and in accordance with alternative embodiments, a dielectric layer 62 may be positioned in a vertical direction beneath the electrode 30 of each of the magnetic-tunnel junction devices 12, 16. Each free layer 26 includes a section that is adjacent to the sidewall 27 of the electrode 30 and another section that is adjacent to the dielectric layer 62. The electrodes 30 and the extent over which the sidewalls 27 adjoin the free layers 26 are effectively shortened by the addition of the dielectric layers 62. The shared top surface 28 of the pinned layer 22, tunnel barrier layer 24, and free layer 26 of each of the magnetic-tunnel-junction devices 12, 16 may be planar and arranged to be coplanar with the top surface 45 of the sections of the dielectric layer 44. Although not shown, the magnetic-tunnel junction devices 14, 18 of the structure 10 may have a similar construction.

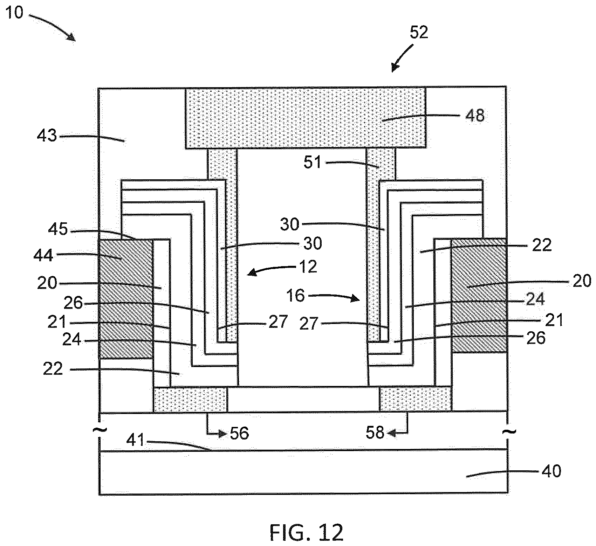

With reference to FIG. 12 in which like reference numerals refer to like features in FIG. 10 and in accordance with alternative embodiments, the structure 10 may be modified such that the electrode 30 of each of the magnetic-tunnel junction devices 12, 16 wraps around the associated electrode 20 and section of the dielectric layer 44 similar to manner in which the pinned layer 22, the tunnel barrier layer 24, and the free layer 26 wrap around the associated electrode 20 and section of dielectric layer 44. A section of each electrode 30 is positioned on the top surface 45 of the associated section of the dielectric layer 44. The electrodes 30 of the magnetic-tunnel-junction devices 12, 16 may be formed by depositing a conformal layer of the electrode material and patterning the deposited layer along with the pinned layer 22, tunnel barrier layer 24, and free layer 26. The vias 51 are extended in length to wrap around the electrodes 30 in order to couple the electrodes 30 to the interconnect 48 of the terminal 52. Although not shown, the magnetic-tunnel junction devices 14, 18 of the structure 10 may have a similar construction.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure for a magnetic-field sensor, the structure comprising:
a first magnetic-tunnel junction device including a first electrode having a first sidewall, a second electrode having a second sidewall facing the first sidewall of the first electrode, a first pinned layer adjacent to the first sidewall of the first electrode, a first free layer adjacent to the second sidewall of the second electrode, and a first tunnel barrier layer between the first free layer and the first pinned layer.

2. The structure of claim 1 wherein the pinned layer adjoins the first sidewall of the first electrode.

3. The structure of claim 1 or claim 2 wherein the free layer adjoins the second sidewall of the second electrode.

4. The structure of one of claims 1 to 3 further comprising:
a first terminal of a Wheatstone bridge; and
a second magnetic-tunnel junction device including a third electrode having a third sidewall, a fourth electrode having a fourth sidewall facing the third sidewall of the third electrode, a second pinned layer adjacent to the third sidewall of the third electrode, a second free layer adjacent to the fourth sidewall of the fourth electrode, and a second tunnel barrier layer between the second free layer and the second pinned layer,
wherein the first free layer is coupled by the first electrode to the first terminal, and the second free layer is coupled by the third electrode to the first terminal.

5. The structure of claim 4 further comprising:
a second terminal of the Wheatstone bridge,
wherein the second electrode is coupled to the second terminal; and/or
a third terminal of the Wheatstone bridge,
wherein the fourth electrode is coupled to the third terminal.

6. The structure of claim 4 or claim 5 wherein the first pinned layer has a first magnetization, the second pinned layer has a second magnetization, and the first magnetization is aligned antiparallel to the second magnetization, and, optionally, wherein the first magnetization is oriented perpendicular to the first sidewall of the first electrode, and the second magnetization is oriented perpendicular to the third sidewall of the third electrode.

7. The structure of one of claims 4 to 6 wherein the first electrode is spaced from the third electrode by a gap, and the first terminal includes an interconnect that is coupled to the first electrode and the third electrode, and the interconnect extends across the gap.

8. The structure of one of claims 1 to 7 further comprising:
a semiconductor substrate having a top surface,
wherein the first pinned layer, the first tunnel barrier layer, and the first free layer share a planar top surface that is coplanar with the top surface of the semiconductor substrate, and, optionally, wherein the structure further comprises an interconnect structure over the semiconductor substrate, the interconnect structure including an interlayer dielectric layer, wherein the first electrode, the first pinned layer, and the first tunnel barrier layer are positioned in the interconnect structure.

9. The structure of one of claims 1 to 7 further comprising:
a semiconductor substrate having a top surface,
wherein the first electrode, the first pinned layer, and the first tunnel barrier layer share a planar top surface that is oriented at an acute angle relative to the top surface of the semiconductor substrate.

10. The structure of one of claims 1 to 9 further comprising:
a dielectric layer over the first electrode, the dielectric layer having a top surface,
wherein the first pinned layer includes a first section on the top surface of the dielectric layer and a second section adjacent to the first sidewall of the first electrode, or wherein the first pinned layer has a section with a top surface that is coplanar with the top surface of the dielectric layer.

11. The structure of claim 10 wherein the first section and the second section of the first pinned layer has substantially equal thicknesses.

12. The structure of one of claims 1 to 9 further comprising:
a dielectric layer adjacent to the first electrode,
wherein the first electrode is positioned between the dielectric layer and the first pinned layer.

13. The structure of one of claims 1 to 12 wherein the first free layer includes a first section adjacent to the second sidewall of the second electrode and a second section adjacent to the first section, and further comprising:
a dielectric layer adjacent to the second section of the first free layer.

14. The structure of one of claims 1 to 3 and 8 to 13 further comprising:
a second magnetic-tunnel junction device including a third electrode having a third sidewall, a second pinned layer adjacent to the first sidewall of the first electrode, a second free layer adjacent to the third sidewall of the third electrode, and a second tunnel barrier layer between the second free layer and the second pinned layer.

15. A method of forming a magnetic-field sensor, the method comprising:
forming a magnetic-tunnel-junction device that includes a first electrode having a first sidewall, a second electrode having a second sidewall facing the first sidewall of the first electrode, a pinned layer adjacent to the first sidewall of the first electrode, a free layer adjacent to the second sidewall of the second electrode, and a tunnel barrier layer between the free layer and the pinned layer.
